# DEMANDE DE BREVET EUROPEEN

(11) **EP 1 035 584 A1**
(43) Date de publication de la demande: **13.09.2000**
(21) Numéro de dépôt: 00400585.6
(22) Date de dépôt: 03.03.2000
(51) Int. Cl.: H01L 23/544, H01L 21/00

(54) **Procédé et dispositif pour dégager une marque de surface d'une plaquette de circuit intégré**

(30) Priorité: 11.03.1999 FR 9903016
(71) Demandeur: STMicroelectronics S.A., 94250 Gentilly (FR); FRANCE TELECOM, 75015 Paris (FR)
(72) Inventeur: Weill, André, 38240 Meylan (FR); Panabiere, Jean-Pierre, 38240 Meylan (FR)
(74) Mandataire: Casalonga, Axel

(57) **Abrégé**

Procédé et dispositif pour créer localement une ouverture dans une couche métallique (6) formée au-dessus d'une face d'une plaquette de base présentant au moins une marque latérale prévue dans son bord périphérique et au moins une marque de surface (8) prévue en un endroit de sa surface, consistant à repérer les coordonnées d'une position d'origine d'un outil (14) par rapport au bord périphérique et à ladite marque latérale de la plaquette de base, à calculer les coordonnées de la position de ladite marque de surface par rapport à la position d'origine précitée de l'outil de façon à déterminer une course à faire de cet outil depuis sa position d'origine jusqu'à une position de travail située au-dessus de ladite marque de surface, à déplacer l'outil (14) de cette course pour l'installer à ladite position de travail, et à activer l'outil de façon à attaquer ladite couche métallique (6) et créer ladite ouverture au-dessus de ladite marque de surface.

## Description

La présente invention concerne un procédé et un dispositif pour dégager une marque de surface d'une plaquette de base de circuit intégré et plus particulièrement un procédé pour créer localement une ouverture dans une couche métallique formée sur une face d'une plaquette de base présentant au moins une marque latérale prévue dans son bord périphérique et au moins une marque de surface prévue en un endroit de sa surface.

Lors de la fabrication d'une plaquette de circuits intégrés, on forme successivement, sur une plaquette de base en silicium, des couches déterminant des empilements de zones métalliques, isolantes et semi-conductrices. La définition et l'obtention de ces zones s'obtiennent par un procédé de photo-lithographie au cours duquel on projette un schéma porté par un masque qui doit à chaque fois être placé dans une position déterminée par rapport à la plaquette. La précision de ce positionnement détermine la précision d'alignement des différentes couches formées successivement sur la plaquette de base. Plus la résolution est grande, plus il est possible d'augmenter le nombre de zones et le nombre de composants intégrés par unité de surface et plus on a besoin d'obtenir une grande précision d'alignement ou de superposition des zones métalliques, isolantes et semi-conductrices.

Selon une première technique connue, les alignements précités sont réalisés par rapport à un réseau de marques gravées en surface de la plaquette de base en silicium. Les masques possédant un réseau correspondant de marques, on effectue l'alignement du réseau de marques des masques avec le réseau de marques de la plaquette de base en utilisant la technique d'interférométrie laser monochromatique.

Pour que cette technique d'alignement par interférométrie laser soit applicable, il est nécessaire que les marques de surface de la plaquette de base en silicium soient visibles optiquement. Pour celà, il est nécessaire de créer des ouvertures dans les niveaux métalliques, successivement, au-dessus de chacune des marques de surface de la plaquette de base en silicium.

Une seconde technique connue consiste à régénérer les marques d'alignement à chaque niveau n des couches pour pouvoir aligner le masque correspondant au niveau n+1. On utilise alors des systèmes de reconnaissance et d'analyse d'images par barrettes CCD ou des systèmes d'analyse de la lumière diffractée par les marques d'alignement réalisées à chaque niveau. Cette seconde technique d'alignement par régénération des marques de la plaquette de base engendre des erreurs à chaque niveau qui successivement s'additionnent. De plus, du fait de la planéité de la surface de la couche métallique, il n'existe plus de marque détectable et l'on doit à nouveau créer localement des ouvertures dans cette couche métallique par enlèvement du métal.

Pour réaliser localement les ouvertures précitées dans les différentes couches métalliques, successivement, on effectue actuellement cette opération par photo-lithographie. Comme il n'est pas nécessaire que les ouvertures précitées soient réalisées avec une grande précision, cette technique longue et coûteuse n'est pas adaptée. Elle comprend en effet une étape de dépôt d'une résine, une étape d'insolation au travers d'un masque délimitant les ouvertures à réaliser, une étape d'enlèvement de la résine au-dessus des ouvertures à réaliser, une étape de gravure des ouvertures dans la couche métallique et une étape d'enlèvement total de la couche de résine.

La présente invention a pour but un procédé pour créer localement les ouvertures précitées de façon nettement plus rapide et nettement moins coûteuse, à l'aide d'un appareillage techniquement et économiquement mieux adapté aux précisions souhaitées.

La présente invention a tout d'abord pour objet un procédé pour créer localement une ouverture dans une couche métallique, formée au-dessus d'une face d'une plaquette de base présentant au moins une marque latérale prévue dans son bord périphérique et au moins une marque de surface prévue en un endroit de sa surface.

Selon l'invention, ce procédé consiste à repérer les coordonnées d'une position d'origine d'un outil par rapport au bord périphérique et à ladite marque latérale de la plaquette de base, à calculer les coordonnées de la position de ladite marque de surface par rapport à la position d'origine précitée de l'outil de façon à déterminer une course à faire de cet outil depuis sa position d'origine jusqu'à une position de travail située au-dessus de ladite marque de surface, à déplacer l'outil de cette course pour l'installer à ladite position de travail, et à activer l'outil de façon à attaquer ladite couche métallique et créer ladite ouverture au-dessus de ladite marque de surface.

Le procédé selon l'invention peut avantageusement consister, pendant l'attaque de ladite couche, à déplacer localement l'outil par rapport à la surface de la plaquette dans la zone de sa position de travail.

Le procédé selon l'invention peut avantageusement consister, après création de ladite ouverture, à effectuer une opération de nettoyage de la surface de la plaquette.

Selon une variante de l'invention, le procédé peut avantageusement consister à mettre une goutte d'un produit d'attaque sélective de la couche métallique en contact avec la surface de la plaquette à l'aide de l'outil placé à sa position de travail.

Selon une autre variante de l'invention, le procédé peut avantageusement consister à créer ladite ouverture par attaque de la couche métallique par un faisceau lumineux issu d'un outil constitué par un laser à excimères agissant par photo-ablation sélective du métal.

Selon une autre variante de l'invention, le procédé peut avantageusement consister à créer ladite ouverture par polissage mécanique ou mécano-chimique de la couche métallique à l'aide d'une tête de polissage et d'un produit d'attaque.

La présente invention a également pour objet un dispositif pour créer localement une ouverture dans une couche métallique formée sur une face d'une plaquette de base présentant au moins une marque latérale prévue dans son bord périphérique et au moins une marque de surface prévue en un endroit de sa surface, pour la mise en oeuvre du procédé précité.

Selon l'invention, ce dispositif peut avantageusement comprendre des moyens de détection de ladite encoche et d'au moins une zone ponctuelle du bord périphérique de ladite plaquette de base afin de constituer un repère de référence, un outil d'attaque de ladite couche métallique, porté par des moyens de déplacement de cet outil par rapport à ladite couche métallique, et des moyens pour déterminer une course de l'outil et commander lesdits moyens de déplacement afin de placer l'outil au-dessus de ladite marque de surface.

Le dispositif selon l'invention peut avantageusement comprendre des moyens pour déplacer localement l'outil au-dessus de ladite marque de surface.

Selon un mode de réalisation de l'invention, l'outil comprend une goutte d'un produit d'attaque de ladite couche métallique.

Selon un autre mode de réalisation de l'invention, ledit outil comprend un émetteur laser à excimères.

Selon un autre mode de réalisation de l'invention, ledit outil comprend une tête de polissage mécanique ou mécano-chimique de ladite couche métallique.

La présente invention sera mieux comprise à l'étude de différentes variantes d'exécution d'un procédé et d'un appareillage pour créer localement des ouvertures dans des couches métalliques formées sur une face de plaquette de base en silicium, décrites à titre d'exemples non limitatifs et illustrés par le dessin sur lequel :
- la figure 1 représente une vue de dessus d'une plaquette ;
- la figure 2 représente une vue de dessus agrandie d'une marque de surface de la plaquette ;
- la figure 3 représente une vue de côté de la plaquette en position de mesure ;
- la figure 4 représente une coupe agrandie de la plaquette dans la zone desdites marques ;
- les figures 5 à 7 représentent des vues en coupe agrandie de la plaquette dans la zone de ladite marque, avec un premier outil d'attaque ;
- les figures 8 à 10 représentent des vues en coupe agrandie de la plaquette dans la zone de ladite marque, avec un second outil d'attaque ;
- les figures 11 à 13 représentent des vues en coupe agrandie de la plaquette dans la zone de ladite marque, avec un troisième outil d'attaque.

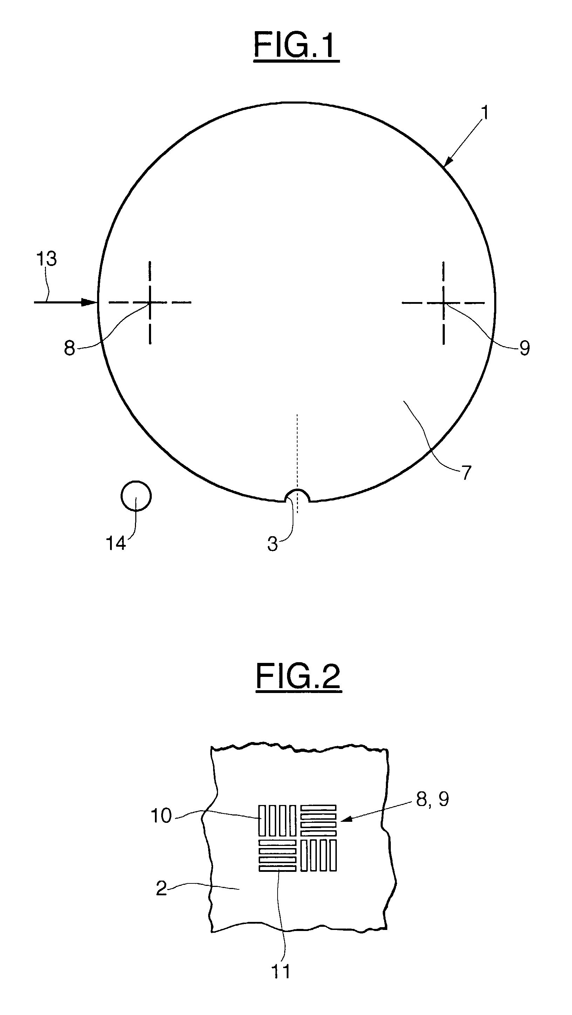

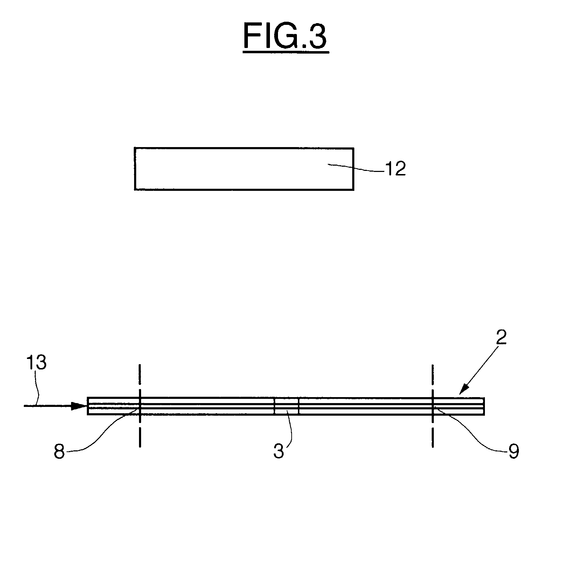

En se reportant en particulier aux figures 1 et 3, on voit qu'on a représenté une plaque de circuit intégré, en cours de fabrication, qui comprend une plaquette circulaire de base 2 en silicium qui comporte une encoche 3 constituant une marque latérale en un endroit de son bord périphérique. Sur une face 4 de la plaquette de base 2 sont formées une couche d'oxyde 5 correspondant à un premier niveau et une couche métallique 6 correspondant à un second niveau. Selon un exemple particulier, la face extérieure de la couche d'oxyde 5 a été préalablement planarisée par polissage mécanique ou mécano-chimique, de telle sorte que la surface extérieure 7 de la couche métallique 6 est plate.

En deux endroits de sa face 4, la plaquette de base 2 en silicium comprend des marques de surface 8 et 9.

Dans l'exemple représenté en particulier sur la figure 2, les marques de surface 8 et 9 sont réalisées par une succession de parties rectilignes creusées 10 délimitant entre elles des parties en saillie 11, réalisées en groupes perpendiculaires entre eux de manière à constituer un motif. Selon une réalisation habituelle, la profondeur des parties en creux 10 est égale à 0,12 micron, la largeur des parties en creux 10 et des parties en saillie 11 est égale à 8 microns et l'ensemble des marques 8 et 9 présentent un contour carré dont le côté est égal à environ 400 microns.

Les marques 8 et 9 sont réalisées en des endroits de la surface de la plaquette de base 2 dont les coordonnées sont connues par rapport à son bord périphérique et à son encoche 7.

On va maintenant décrire comment on peut réaliser des ouvertures dans la couche métallique 6.

Une première étape consiste à constituer un repère de référence Rr en (x, y) selon le plan de la plaquette 2 à l'aide d'un appareil de détection optique 12 représenté schématiquement sur la figure 3, qui détecte l'encoche périphérique 3 et une zone ponctuelle 13 du bord périphérique de cette plaquette, située à 90° par rapport à l'encoche 3.

Ce repère de référence étant constitué, une seconde étape consiste à repérer les coordonnées d'une position d'origine Po d'un outil 14 par rapport au repère de référence Rr.

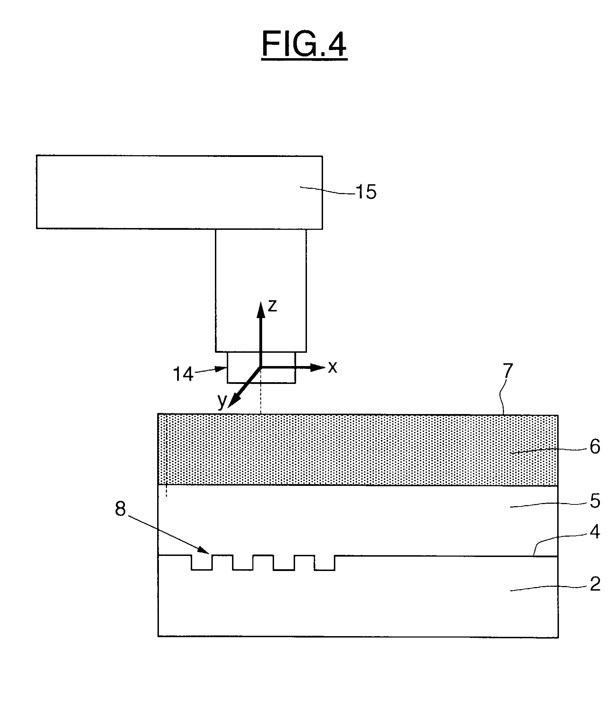

Comme le montre la figure 4, cet outil 14 est porté par un appareil 15 permettant son déplacement en (x, y et z).

Une troisième étape consiste à déterminer par calcul les coordonnées Cm de la marque de surface 8 par rapport à la position d'origine Po précitée de l'outil 14, de façon à déterminer une course Co en (x, y) que cet outil 14 doit faire pour passer de sa position d'origine Po précitée jusqu'à une position de travail Pt située au-dessus de la marque de surface 8.

Une quatrième étape consiste à déplacer l'outil 14 en activant l'appareil 15 de façon à le placer à sa position de travail Pt située au-dessus de la marque de surface 8 comme le montre la figure 4.

L'outil 14 étant disposé à sa position de travail Pt au-dessus de la marque de surface 8, on peut alors l'activer de façon à attaquer sélectivement la couche métallique 6 afin de créer une ouverture 16 dont la surface est de préférence largement supérieure à la surface de la marque de surface 8.

On va maintenant décrire différents outils 14 adaptés pour créer l'ouverture 16.

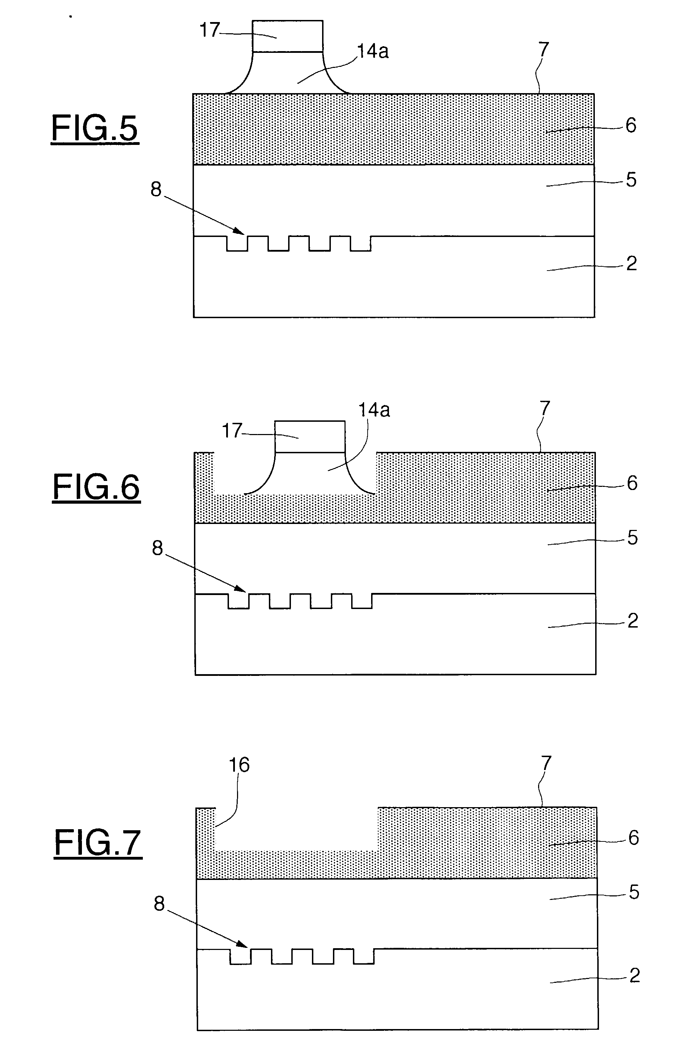

Dans l'exemple des figures 5-7, l'outil 14 comprend une goutte 14a d'un produit chimique adapté pour attaquer de façon sélective la couche métallique 6, qui est portée par l'extrémité d'un porte-goutte 17 fixé à l'appareil de déplacement 15.

On active cet appareil de déplacement 15 de manière à mettre la goutte 14a en contact avec la surface 7 de la couche métallique 6.

L'appareil 15 est commandé de façon à déplacer la goutte 14a en surface de manière à couvrir la surface de l'ouverture 16 à créer et à déplacer vers le bas cette goutte au fur et à mesure de l'attaque de la couche métallique 6.

Lorsque la couche métallique 6 est attaquée dans toute son épaisseur jusqu'à la couche sous-jacente 5, sans attaquer cette dernière, le porte-goutte 17 aspire la goutte 14a de façon à dégager l'ouverture 16. Dans une étape ultérieure, on procède à un lavage de la surface 7 notamment dans la zone de l'ouverture 16 créée.

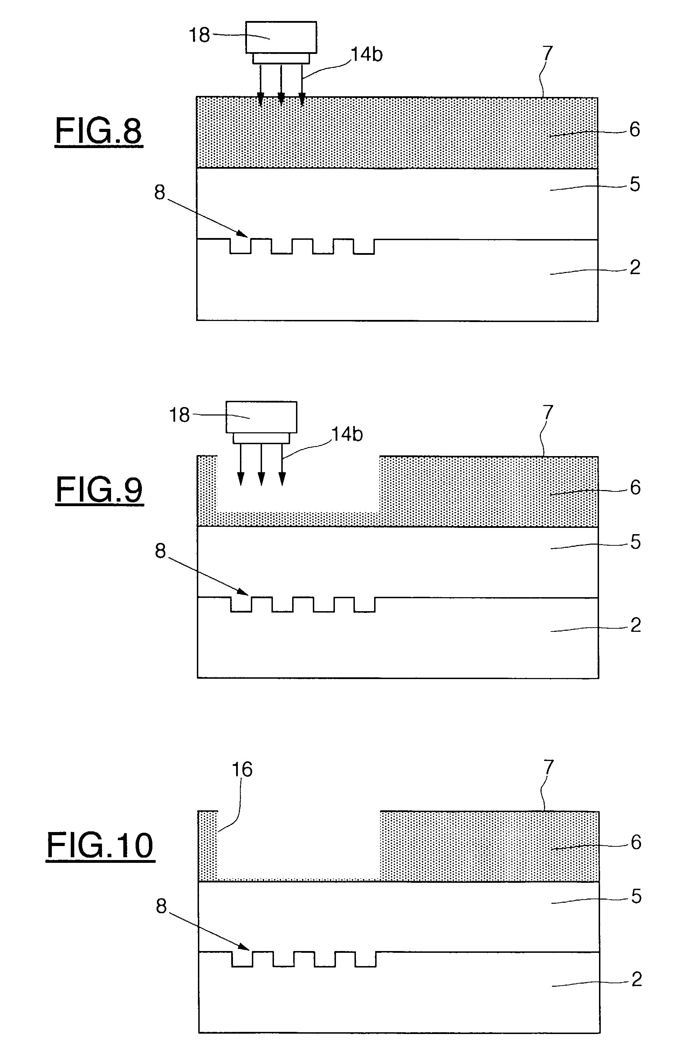

Dans l'exemple des figures 8-10, l'outil 14 comprend un faisceau lumineux 14b émis vers la couche 6 par un émetteur laser 18 à excimères porté par l'appareil de déplacement 15.

Comme dans l'exemple précédent, l'appareil de déplacement 15 déplace l'émetteur laser 18 de façon à ce que le faisceau de lumière 14a érode la couche métallique 6 par photo-ablation sélective du métal jusqu'à créer l'ouverture 16 souhaitée au-dessus de la marque de surface 8.

Lorsque cette ouverture 16 est créée, on procède ultérieurement à une étape de nettoyage de la surface de la plaque 1 notamment dans la zone de l'ouverture 16.

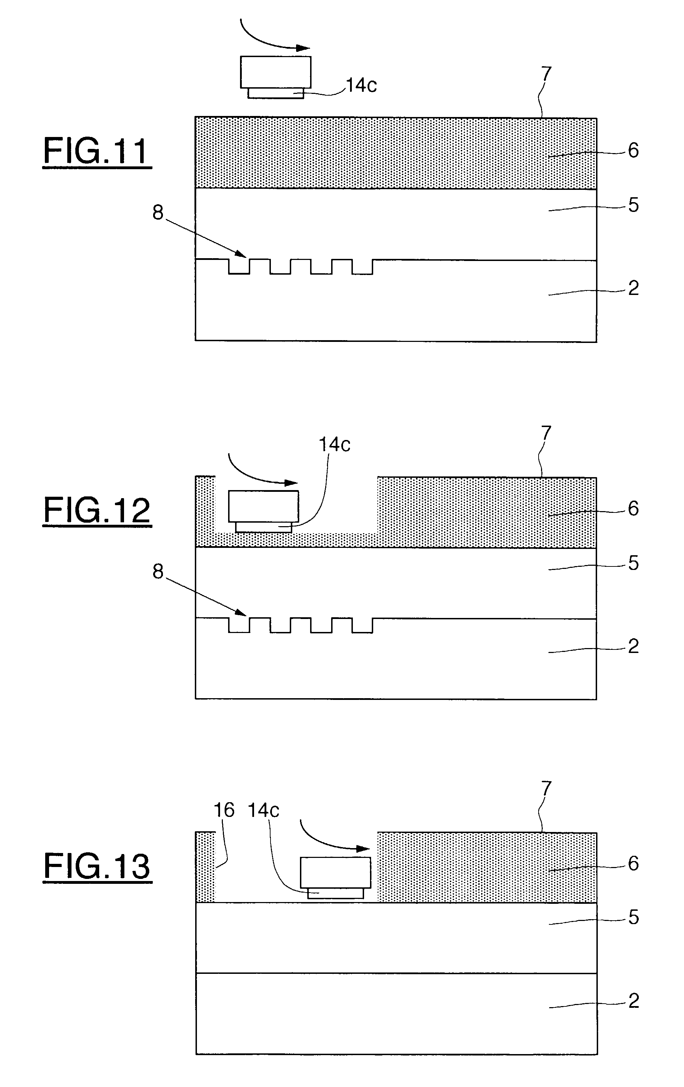

Dans l'exemple des figures 11-13, l'outil 14 comprend une tête rotative 14c de polissage mécanique ou mécano-chimique, connue en soi, dimensionnée de façon à créer l'ouverture 16 souhaitée.

Comme dans les exemples précédents, l'appareil de déplacement 15 déplace la tête de polissage 14c en surface de façon à couvrir la dimension de l'ouverture 16 souhaitée et pénètre dans la couche métallique 6 sur l'épaisseur de cette couche de façon à dégager l'ouverture 16 jusqu'à la couche sous-jacente 5, sans attaquer la couche sous-jacente 5.

Comme dans les exemples précédents, on procède à une étape ultérieure de nettoyage de la plaque 1 notamment dans la zone de l'ouverture 16 créée.

Pour créer une ouverture correspondante 16 au-dessus de la marque de surface 9 dans la couche métallique 6, on procède comme décrit ci-dessus.

Les étapes et opérations qui viennent d'être indiquées sont réalisées grâce à des moyens électroniques programmés dont les caractéristiques sont connues en soi.

Ces ouvertures 16 étant désormais créées dans la couche métallique 10 de la plaque 1, les marques de surface 8 et 9, qui sont maintenant optiquement visibles au travers des ouvertures 16, constituent des repères d'alignement utilisables dans le cadre d'un processus ultérieur de photolithographie de la couche métallique 6, lesdites marques étant détectables par interférométrie laser monochromatique.

La présente invention ne se limite pas aux exemples ci-dessus décrits. Bien d'autres variantes de réalisation sont possibles sans sortir du cadre défini par les revendications annexées.

## Revendications

1. Procédé pour créer localement une ouverture dans une couche métallique formée au-dessus d'une face d'une plaquette de base présentant au moins une marque latérale prévue dans son bord périphérique et au moins une marque de surface prévue en un endroit de sa surface, caractérisé par le fait qu'il consiste :
- à repérer les coordonnées d'une position d'origine d'un outil par rapport au bord périphérique et à ladite marque latérale de la plaquette de base,
- à calculer les coordonnées de la position de ladite marque de surface par rapport à la position d'origine précitée de l'outil de façon à déterminer une course à faire de cet outil depuis sa position d'origine jusqu'à une position de travail située au-dessus de ladite marque de surface,
- à déplacer l'outil de cette course pour l'installer à ladite position de travail,
- et à activer l'outil de façon à attaquer ladite couche métallique et créer ladite ouverture au-dessus de ladite marque de surface.

2. Procédé selon la revendication 1, caractérisé par le fait qu'il consiste, pendant l'attaque de ladite couche, à déplacer localement l'outil par rapport à la surface de la plaquette dans la zone de sa position de travail.

3. Procédé selon l'une des revendications 1 et 2, caractérisé par le fait qu'il consiste, après création de ladite ouverture, à effectuer une opération de nettoyage de la surface de la plaquette.

4. Procédé selon l'une quelconque des revendications précédentes, caractérisé par le fait qu'il consiste à mettre une goutte d'un produit d'attaque sélective du métal en contact avec la surface de la plaquette à l'aide de l'outil placé à sa position de travail.

5. Procédé selon l'une quelconque des revendications 1 à 3, caractérisé par le fait qu'il consiste à créer ladite ouverture par attaque de la couche métallique par un faisceau lumineux issu d'un outil constitué par un laser à excimères agissant par photo-ablation sélective du métal.

6. Procédé selon l'une quelconque des revendications 1 à 3, caractérisé par le fait qu'il consiste à créer ladite ouverture par polissage sélectif mécanique ou mécano-chimique de la couche métallique à l'aide d'une tête de polissage et d'un produit d'attaque.

7. Dispositif pour créer localement une ouverture dans une couche métallique formée sur une face d'une plaquette de base présentant au moins une marque latérale prévue dans son bord périphérique et au moins une marque de surface prévue en un endroit de sa surface, pour la mise en oeuvre du procédé selon l'une quelconque des revendications précédentes, caractérisé par le fait qu'il comprend :
- des moyens de détection (12) de ladite encoche et d'au moins une zone ponctuelle du bord périphérique de ladite plaquette de base afin de constituer un repère de référence,
- un outil (14) d'attaque de ladite couche métallique, porté par des moyens de déplacement de cet outil par rapport à ladite couche métallique,
- et des moyens (15) pour déterminer une course de l'outil et commander lesdits moyens de déplacement afin de placer l'outil au-dessus de ladite marque de surface.

8. Dispositif selon la revendication 7, caractérisé par le fait qu'il comprend des moyens pour déplacer localement l'outil au-dessus de ladite marque de surface.

9. Dispositif selon la revendication 7, caractérisé par le fait que l'outil comprend une goutte (14a) d'un produit d'attaque de ladite couche métallique.

10. Dispositif selon la revendication 7, caractérisé par le fait que ledit outil comprend un émetteur laser à excimères (14b).

11. Dispositif selon la revendication 7, caractérisé par le fait que ledit outil comprend une tête (14c) de polissage mécanique ou mécano-chimique de ladite couche métallique.
